# EUROPÄISCHE PATENTSCHRIFT

(11) **EP 1 519 399 B1**
(45) Veröffentlichungstag und Bekanntmachung des Hinweises auf die Patenterteilung: **19.10.2011**
(21) Anmeldenummer: 04017437.7
(22) Anmeldetag: 23.07.2004
(51) Int. Cl.: H01J 37/02, H01J 37/09, H01J 37/20

(54) **Teilchenstrahlgerät mit gekühltem Antikontaminator und/oder Probenhalter**
Particle beam apparatus with cooled anti-contamination shield and/or sample holder
Dispositif à faisceau de particules avec écran anti-contamination et/ou porte-échantillon refroidis

(30) Priorität: 24.09.2003 DE 10344492
(43) Veröffentlichungstag der Anmeldung: 30.03.2005
(73) Patentinhaber: Carl Zeiss NTS GmbH, 73447 Oberkochen (DE)
(72) Erfinder: Müller, Helmut, 73527 Schwäbisch Gmünd (DE)
(74) Vertreter: Gnatzig, Klaus

(56) Entgegenhaltungen:
- EP-A- 1 351 271
- JP-A- 61 042 843
- US-A- 4 163 900
- US-A- 4 591 722
- US-A- 5 077 637
- US-A1- 2002 182 397
- CITEC INDUSTRIES INC.: 'ThermalGraph 6000X Panels' CYTEC ENGINEERED MATERIALS, [Online] 2008, Gefunden im Internet: <URL:http://dev.cytec.com/engineered-materi als/products/cfThermalGraph6000X.htm>

## Beschreibung

Die Erfindung betrifft Teilchenstrahlgeräte mit Strahlen geladener Teilchen, insbesondere Teilchenstrahlgeräte wie Transmissionselektronenmikroskope und Rasterelektronenmikroskope. Konkreter betrifft die Erfindung derartige Teilchenstrahlgeräte mit gekühlten Bauteilen in der Nähe einer aufzunehmenden Probe.

In Elektronenmikroskopen, insbesondere Transmissionselektronenmikroskopen, bei denen im Bereich der zu mikroskopierenden Probe ein gutes Vakuum erforderlich ist, tritt das Problem auf, dass aus der Probe ausgasende Stoffe das Vakuum verschlechtern, d.h. das Vakuum kontaminieren. Um derartige Kontaminationen des Vakuums zu vermeiden können in der Nähe der aufzunehmenden Probe innerhalb der Vakuumsäule sogenannte Antikontaminatoren angeordnet werden, die gekühlt werden. Durch die geringere Temperatur der Antikontaminatoren gegenüber der Umgebungstemperatur innerhalb der Vakuumsäule kondensieren aus der Probe austretende Gase an den Antikontaminatoren, wodurch eine Beibehaltung der Qualität des Vakuums erreicht wird. Die Antikontaminatoren wirken gewissermaßen als Cryopumpen. Durch die Beibehaltung der Qualität des Vakuums im Probenbereich, wird gleichzeitig auch eine Kontamination der Probe durch an der Probe kondensierende Restgasmoleküle des Vakuums reduziert, wodurch die Probenqualität über eine längere Zeit beibehalten wird.

Darüber ist es auch möglich, kühlbare Probenmanipulatoren vorzusehen, durch die die Probe bei der elektronenmikroskopischen Untersuchung gekühlt werden kann. Gekühlte Probenmanipulatoren wirken dabei ebenfalls als Antikontaminatoren. Außerdem kann die Probe dadurch während der elektronenmikroskopischen Untersuchung auf einer entsprechend geringen Temperatur gehalten werden.

Für die Kühlung der Antikontaminatoren und/oder des Probenhalters kann ein außerhalb des Vakuumssystems angeordneter Kühler vorgesehen sein, zu dem die Wärme des Antikontaminators und/oder des Probenhalters abgeführt wird. Für die Abführung der Wärme von den Antikontaminatoren und/oder dem Probenhalter zum Kühler sind bisher Wärmeleiter aus Kupfer oder Kupferdrähten eingesetzt. Nachteilig ist dabei, dass durch den hohen Längenausdehnungskoeffizient des Kupfers bei Abkühlung auf die Temperatur des Kühlers, in der Regel flüssiger Stickstoff, erhebliche Schrumpfungen des Wärmeleiters auftreten. Diese Längenänderungen müssen durch geeignete elastische Lagerungen des Kühlstabes und des mit dem Kryogen gefüllten Gefäßes kompensiert werden. Dieses ist stets mit den Wirkungsgrad der Kühlung mindernden Kühlverlusten verbunden. Des weiteren stellt die Wärmeleitfähigkeit des Kupfers für den Wärmefluss vom Antikontaminator und/oder dem Probenhalter zum Kühler einen Widerstand dar. Dieser Widerstand begrenzt die Minimaltemperatur, die am Antikontaminator realisiert werden kann und damit dessen Leistungsfähigkeit.

Als Stand der Technik im Zusammenhang mit der vorliegenden Erfindung sind insbesondere die US 4,179,605, die US 4,833,330, die WO 83/03707 und die WO 02/26479 anzuführen. Die WO 02/26479 liegt dabei nicht auf dem Gebiet der Teilchenstrahlgeräte, sondern auf dem Gebiet von Halbleiterbauelementen.

Aus der nachveröffentlichten EP 1351271 A1 ist ein Manipulator für ein optisches oder teilchenoptisches Gerät bekannt.

Aus der JP 61042843 A1 ist ein kühlbarer Substrathalter bekannt, bei dem zur Ableitung der Wärme zwischen dem Substrat und dem Substrathalter Metallfasern vorgesehen sind.

Es ist das Ziel der vorliegenden Erfindung, die mit dem Stand der Technik verbundenen Nachteile zu vermeiden. Aufgabe der vorliegenden Erfindung ist es dabei insbesondere, die Wärmeleitfähigkeit zwischen dem Antikontaminator und/oder dem Probenhalter und dem Kühler deutlich zu erhöhen. Ein weiteres Ziel der Erfindung ist es außerdem, die bei einer Abkühlung des Wärmeleiters auftretende Schrumpfung des Wärmeleiters bzw. bei einer Erwärmung des Wärmeleiters auftretende Dehnung des Wärmeleiters zu reduzieren.

Das vorstehend genannte Ziel wird erfindungsgemäß durch ein Teilchenstrahlgerät mit den Merkmalen des Anspruches 1 gelöst. Vorteilhafte Ausgestaltungen der Erfindung ergeben sich aus den Merkmalen der abhängigen Anspüche.

Das erfindungsgemäße Teilchenstrahlgerät weist ein Objektiv auf, das einen Teilchenstrahl fokussiert oder abbildet. Weiterhin weist das Teilchenstrahlgerät einen Probenhalter auf, auf dem eine Probe in dem Objektiv oder in der Nähe des Objektivs aufnehmbar ist. Weiterhin ist ein Kühler und ein Wärmeleiter vorgesehen, wobei der Wärmeleiter zur Ableitung von Wärme vom Probenhalter oder von in der Nähe des Probenhalters angeordneten Kühlflächen zum Kühler dient. Der Wärmeleiter enthält Kohlefasern.

Durch den Einsatz von Kohlefasern als Wärmeleiter wird gegenüber dem Einsatz von Kupfer als Wärmeleiter eine um etwa den Faktor 3 höhere Wärmeleitung erreicht. Dadurch wird der Wärmeleitwiderstand bei ansonsten gleichen Verhältnissen um einen Faktor 3 geringer gegenüber dem Einsatz von Kupferstäben als Wärmeleiter, wodurch am Kühlort, den Kühlflächen und/oder dem Probenhalter, eine niedrigere Temperatur erreichbar ist. Gleichzeitig ist der lineare Wärmeausdehungskoeffizient von Kohlefasern im Vergleich zum linearen Wärmeausdehnungskoeffizienten von Kupfer sehr gering. Dadurch kann bei geeigneter Abstimmung mit der Anschlussgeometrie ein Gesamtdehnungsverhalten von annähernd 0 erzielt werden.

Da Kohlefasermaterial in seiner Ursprungsform als Faser vorliegt, kann die Verbindung zwischen dem Kühler und den Kühlflächen und/oder dem Probenhalter aus einem elastischen Faserbündel hergestellt werden. Dadurch wird gleichzeitig der Vorteil erreicht, dass nahezu jegliche mechanische Kopplung zwischen dem Kühler und dem zu kühlenden Bauteil, insbesondere die Übertragung von Schall und mechanischen Schwingungen nahezu ausgeschlossen wird.

Nachfolgend werden Einzelheiten der Erfindung anhand des in den Figuren dargestellten Ausführungsbeispiels näher erläutert. Dabei zeigen:
- Figur 1:: eine schematische Darstellung eines erfindungsgemäßes Teilchenstrahlgerät in Form eines Transmissionselektronenmikroskopes im Schnitt,
- Figur 2:: einen Schnitt durch den Wärmeleiter in Figur 1 entlang der Schnittebene II/II, und
- Figur 3:: eine schematische Darstellung eines erfindungsgemäßen Teilchenstrahlgeräts in Form eines Rasterelektronenmikroskops im Schnitt.

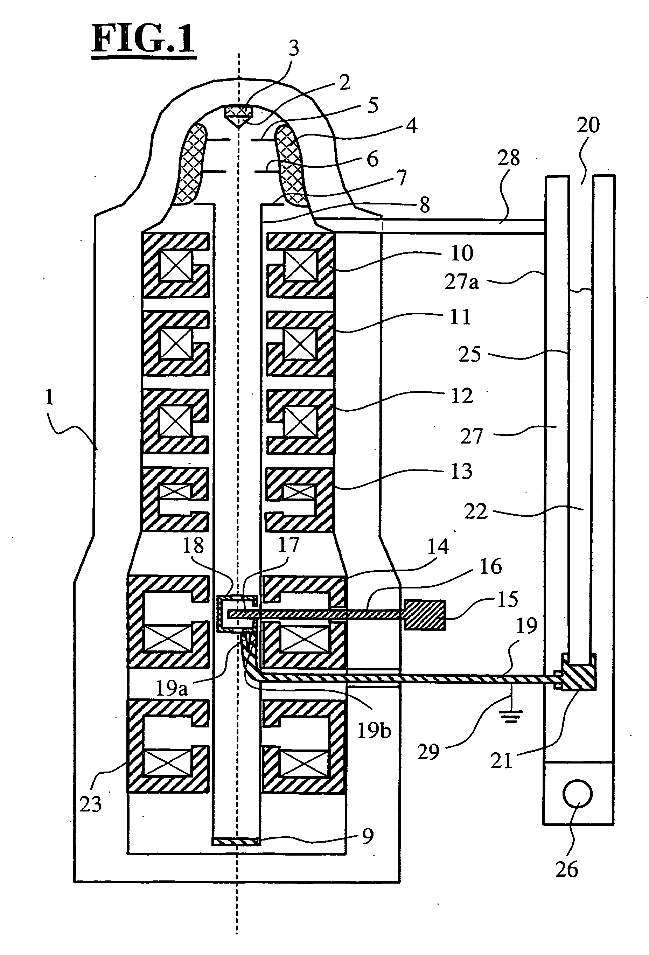

Das Teilchenstrahlgerät in Figur 1 weist eine Vakuumsäule (1) auf, in der die elektronenoptischen Komponenten angeordnet sind. Die elektronenoptischen Komponenten umfassen in diesem Ausführungsbeispiel insbesondere eine Elektronenquelle (2), die an einem Isolator (3) innerhalb der Vakuumsäule aufgenommen ist. An einem weiteren Isolator (4) sind mehrere Beschleunigungselektroden (5, 6, 7) innerhalb der Vakuumsäule aufgenommen, die gegenüber der Elektronenquelle (2) auf positivem Potential liegen. Die von der Elektronenquelle (2) am weitesten entfernte Elektrode (7) bildet die Anode, die die Endenergie des Elektronenstrahls definiert. Die Anode (7) liegt typischerweise gegenüber der Elektronenquelle (2) auf einem 100-200 kV, gegebenenfalls auch 300 kV, höherem Potenzial und liegt gleichzeitig auf dem Potenzial der Vakuumsäule, d.h. in der Regel auf Massepotenzial. Die Anode (7) ist mit einem Strahlführungsrohr (8), das elektrisch leitend ist, verbunden. Das Strahlführungsrohr (8) zieht sich durch das gesamte Teilchenstrahlgerät bis hin zu einem_Detektor (9) hindurch, so dass von der Anode (7) bis zum Detektor (9) das Anodenpotenzial besteht.

Auf die Anode (7) folgt entlang des Strahlführungsrohres (8) ein elektronenoptisches Kondensorsystem, das im dargestellten Ausführungsbeispiel vier Magnetlinsen (10, 11, 12, 13) enthält. Durch dieses mehrstufige Kondensorsystem ist die Beleuchtungsapertur sowie das Leuchtfeld der aus der Elektronenquelle (2) austretenden Elektronen in einer Probenebene durch entsprechende Änderung der Anregungen der einzelnen Magnetlinsen (10, 11, 12, 13) über einen weiten Bereich beliebig variierbar. Im Strahlengang zwischen den Kondensorlinsen (10, 11, 12, 13) sind noch hier nicht dargestellte Blenden zur Definition der Beleuchtungsapertur und/oder des Leuchtfeldes vorgesehen. Auch können hier im Beleuchtungssystem noch zusätzliche Strahlablenker und/oder Mehrfachblenden angeordnet sein, wie dieses beispielsweise aus der EP 384 273 bekannt ist.

Auf das mehrstufige Beleuchtungssystem mit den Magnetlinsen (10, 11, 12, 13) folgt eine Kondensorobjektiveinfeldlinse (14), die gleichzeitig als letzte Kondensorlinse und als Objektivlinse dient. Durch eine Bohrung durch den Polschuh der Kondensorobjektiveinfeldlinse auf der Höhe des Polschuhspaltes ist ein Probenhalter (17) an einem Probenmanipulator aufgenommen. Der Probenmanipulator weist dabei eine Manipulationsstange (16) auf, die durch den Polschuh der Kondensorobjektiveinfeldlinse (14) hindurch geführt ist und weiterhin durch das Vakuumrohr (1) hindurchgeführt ist und von außen über eine von außen am Vakuumrohr (1) angeflanschte Manipulationsmimik in drei zueinander senkrechten Raumrichtungen parallel und senkrecht zur gestrichelt dargestellten optischen Achse bewegbar ist. Eine Bewegung der Manipulatorantriebe (15) wird dabei über eine Übertragungsstange (16) auf den Probenhalter (17) übertragen. Hinsichtlich des näheren Aufbaus eines entsprechenden Manipulators sei beispielsweise auf die noch nicht veröffentlichte deutsche Patentanmeldung DE 102 12 807.3 der Anmelderin verwiesen. Alternativ zu einer manuellen Probenmanipulation ist auch eine motorische Ansteuerung und Bewegung der Manipulatorstange (16) möglich.

Auf der Höhe des Polschuhspaltes der Kondensorobjektiveinfeldlinse (14) ist innerhalb des Strahlführungsrohres (8) ein Antikontaminator (18) angeordnet. Der Antikontaminator (18) besteht dabei im wesentlichen aus einem mehr oder minder kastenförmigen Gehäuse, das den Probenhalter (17) kastenförmig umgibt und das im wesentlichen koaxial zur optischen Achse zwei Löcher, z.B. Bohrungen, für den Durchtritt des Elektronenstrahls aufweist. Im wesentlichen senkrecht und geneigt zur optischen Achse weist der Antikontaminator weitere Öffnungen auf, die zur Durchführung des Probenhalters (17) sowie zur Einführung von Detektoren dienen können. Die Innenflächen des Antikontaminators (18) bilden Kühlflächen, die dafür sorgen, dass im Restgas des Vakuums enthaltene Moleküle auf den inneren Kühlflächen des Antikontaminators kondensieren.

Auf die Kondensorobjektiveinfeldlinse (14) folgt ein ein- oder zweistufiges Probjektivsystem (23), durch das eine auf dem Probenhalter (17) aufgenommene und über das mehrstufige Beleuchtungssystem beleuchtete Probe vergrößert auf einen Detektor (9), beispielsweise eine für Elektronen empfindliche CCD-Kamera abgebildet wird. Die mittels der CCD-Kamera (9) aufgezeichneten Bilder sind auf einem nicht dargestellten Display darstellbar oder über eine ebenfalls nicht dargestellte Bildverarbeitung zu verarbeiten und abzuspeichern.

Zur Kühlung des Antikontaminators (18) und des Probenhalter (17) ist ein Kryogefäß vorgesehen, das außerhalb der Vakuumsäule (1) angeordnet ist. Das Kryogefäß enthält einen im wesentlichen zylindrischen inneren Behälter (20), der zur Aufnahme eines flüssigen Kryogens ausgebildet ist und beispielsweise mit flüssigem Stickstoff befüllbar ist. Im Bodenbereich ist der innere Behälter von einem mit dem Behälter in direktem mechanischen Kontakt stehenden Kühler (21) umgeben, der durch verdampfendes Kryogen gekühlt wird. Der Kühler (21) ist dabei metallisch, z.B. aus Kupfer. Zur Wärmeleitung zwischen dem Kühler (21) und dem Probenhalter (17) bzw. Antikontaminator (18) ist ein Wärmeleiter (19) aus Kohlfasem vorgesehen. Wie die Schnittdarstellung in Figur (2) zeigt, weist der Wärmeleiter (19) ein Bündel an Kohlefasern (23) auf. Der Kühler (21) kann beispielsweise eine Aluminium Gussteil sein, das an eines der Enden des Wärmeleiters (19) angegossen ist, so dass eine gute Wärmeleitung zwischen dem Wärmeleiter und dem Kühler (21) gewährleistet ist.

Der Innere Behälter (20) ist von einem äußeren Behälter (27) umgeben. Der äußere Behälter (27) ist nach oben geschlossen, während der innere Behälter nach oben für einen Gasaustritt geöffnet ist. Der Zwischenraum zwischen den Wänden (27a) des äußeren Behälters (27) und den Wänden (25) des inneren Behälters (20) ist durch eine Vakuumpumpe (26) evakuiert. Durch das Vakuum zwischen dem inneren Behälter und dem äußeren Behälter (27) besteht eine thermische Isolierung zwischen dem inneren Behälter und dem äußeren Behälter, wodurch ein zu schnelles und nutzloses Verdampfen des Kryogens vermieden ist.

Neben der Kühlung des Kühlers (21) erfüllt der Gesamtaufbau des Kryogefäßes noch einen weiteren Zweck, denn die Gesamtanordnung wirkt gleichzeitig als Kryopumpe, weil das zwischen dem inneren und dem äußeren Behälter befindliche Restgas an der Wand (25) des inneren Behälters kondensiert. Aufgrund des dadurch erzielten guten Vakuums im Zwischenraum zwischen dem inneren und äußeren Behälter, wird die so gebildete Kryopumpe genutzt, um den zur Elektronenquelle (2) nahen Raum der Vakuumsäule (1) zu evakuieren, wozu der zur Elektronenquelle (2) nahe Raum der Vakuumsäule (1) und der Zwischenraum zwischen dem inneren und äußeren Behälter durch ein Saugrohr (28) verbunden sind.

Der Wärmeleiter (19) ist durch das Vakuumrohr (1) in das innere des Strahlführungsrohres (8) hindurchgeführt und unmittelbar vor dem Antikontaminator (18) und dem Probenhalter (17) in zwei Teilbündel aufgeteilt. Eines der Teilbündel (19a) ist am Antikontaminator (18) angeschlossen und dient zur Ableitung von Wärme bzw. zur Kühlung des Antikontaminators (18) ein zweites Teilbündel (19b) ist an den Probenhalter (17) angeschlossen und dient zur Kühlung des Probenhalter (17). Die thermisch gut leitende Anbindung zwischen dem Wärmeleiter (19 und den zu kühlenden Bauteilen kann dadurch erfolgen, das an das antikontaminatorseitige Ende des einen Teilbündels (19a) des Wärmeleiters und /oder an das probenhalterseitige Ende des anderen Teilbündels (19b) des Wärmeleiters jeweils ein metallisches Übergangsteil angegossen ist, so dass ein vollflächiger Kontakt zwischen den Enden der Kohlefasern des Wärmeleiters (19) mit dem metallischen Übergangsteil gewährleistet ist. Das metallische Übergangsteil kann dann mit dem zu kühlenden Bauteil verschraubt oder verlötet sein.

Durch die gute elektrische Leitfähigkeit der Kohlefasern des Wärmeleiters werden elektrische Aufladungseffekte im Bereich der Probe und/ oder des Antikontaminators vermieden. Der Wärmeleiter (19) ist dazu über einen starke Erdleitung (29) separat geerdet.

Das in der Figur 1 dargestellte Transmissionselektronenmikroskop bildet ein Teilchenstrahlgerät mit einem Objektiv (14), das einen Teilchenstrahl fokussiert. Es enthält einen Probehalter (17), auf dem eine Probe im Objektiv (14) aufnehmbar ist. Es enthält weiterhin einen Kühler (21) und einen Wärmeleiter (19), der an den Kühler (21) und and den Probenhalter(17) und an den Antikontaminator (18), dessen Flächen Kühlflächen bilden, angeschlossen, so dass der Probenhalter und der Antikontaminator (18) thermisch leitend mit dem Kühler (21) verbunden sind. Der Wärmeleiter (19) dient dadurch zur Ableitung von Wärme vom Probenhalter und dem Antikontaminator zum Kühler. Der Wärmeleiter enthält dabei Kohlefasern.

Um eine gute thermische Kopplung zwischen dem Probenhalter und dem Antikontaminator einerseits, und dem Kühler (21) andererseits zu gewährleisten, sind die Stirnflächen der Kohlefasern formschlüssig mit metallischen Teilen des Probenhalters (17), des Antikontaminators (18) und des Kühlers (21) verbunden, oder es sind Verbindungsteile vorgesehen, die Stirnflächen der Kohlefasern formschlüssig umgeben und mit metallischen Teilen des Probenhalters (17), des Antikontaminators (18) und des Kühlers (21) flächig verbunden sind.

Bei dem in der Figur 1 dargestellten Ausführungsbeispiel sind sowohl der Probenhalter als auch der Antikontaminator über den Wärmeleiter (19) thermisch leitend mit dem Kühler (21) verbunden. Es ist jedoch auch möglich, entweder nur den Antikontaminator (18) oder nur den Probenhalter zu kühlen und entsprechend einen Kohlefasern aufweisenden Wärmeleiter nur zwischen dem Probenhalter (17) und dem Kühler (21) oder, alternativ, nur zwischen dem Antikontaminator (18) und dem Kühler (21) vorzusehen.

Ist eine Kühlung von zwei oder mehr Bauteilen erforderlich, so ist es möglich, einen Kohlefasern aufweisenden Wärmeleiter im Bereich der zu kühlenden Bauteile in zwei oder mehrere Teilbündel (19a, 19b) aufzuteilen oder jeweils ein Teilbündel (19a, 19b) mit einem zu kühlenden Bauteil thermisch leitend zu verbinden. Alternativ ist es jedoch auch möglich, separate Wärmeleiter zwischen jedem zu kühlenden Bauteil und dem Kühler (21) vorzusehen. Letzteres bietet sich insbesondere an, wenn die zu kühlenden Bauteile weiter von einander beabstandet sind.

Bei der in der Figur 1 dargestellten Ausführungsform der Erfindung ist ein Behälter (20), ein Deward-Gefäß, zur Aufnahme eines flüssigen Kryogens vorgesehen und der Kühler (21) in dem Behälter angeordnet. Durch Befüllen des Behälters mit beispielsweise flüssigem Stickstoff ist so mit geringem technischen Aufwand eine starke Kühlung des Antikontaminators und /oder des Probenhalters möglich.

Bei der in der Figur 1 dargestellten Ausführungsform der Erfindung ist der Behälter (20), der zur Aufnahme eines flüssigen Kryogens dient, außerhalb der Vakuumsäule angeordnet und der Wärmeleiter (19) vom Kühler (21) ausgehend bis in die Vakuumsäule hinein geführt. Dadurch ist ein sehr einfaches Befüllen oder Nachfüllen des Kryogens möglich. Außerdem sind keine besonderen Maßnahmen zur Herausführung des verdampften Kryogens aus der Vakuumsäule erforderlich. Es ist jedoch auch möglich, den Behälter innerhalb der Vakuumsäule anzuordnen, wenn geeignete Leitungen zur Abführung von Kryogendämpfen zusätzlich vorgesehen sind. Weiterhin ist es auch möglich, den Behälter in den Manipulator (15) des Probenhalters zu integrieren; in diesem Fall kann die Manipulationsstange (16) als Rohr ausgebildet sein und in ihrem Inneren den Kohlefasern enthaltenden Wärmeleiter aufnehmen.

Der Wärmeleiter aus Kohlefasern ist vorzugsweise elastisch und biegsam. Außerdem sollte der Wärmeleiter (19) nicht untermechanischer Spannung stehen. Dadurch wird die Übertragung von mechanischen Schwingungen, die insbesondere durch verdampfendes Kryogen (22) entstehen können, vermieden.

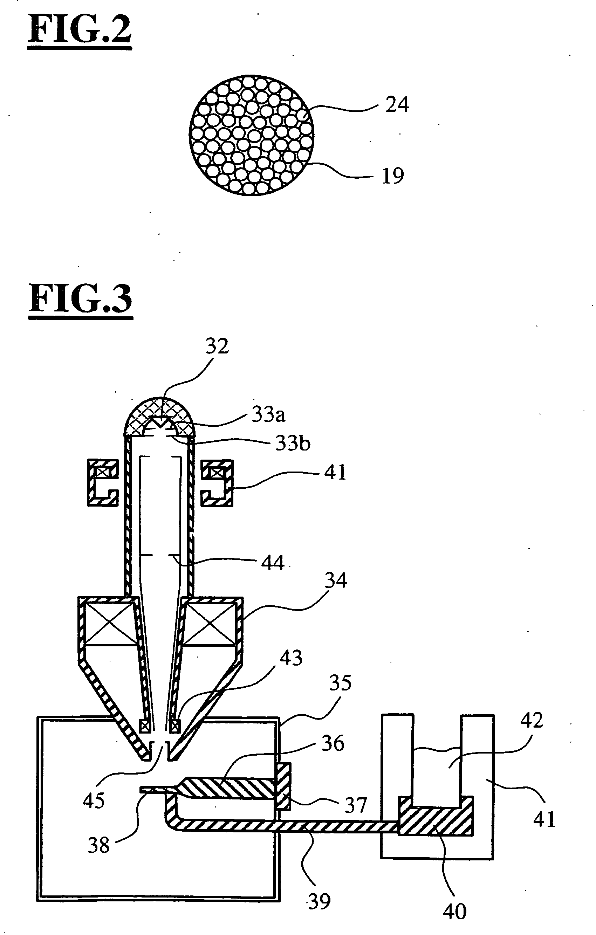

Bei dem in der Figur 1 dargestellten Ausführungsbeispiels ist der Antikontaminator und der Probenhalter (17) im Bereich des Polschuhspaltes der Kondensorobjektiveinfeldlinse angeordnet. Alternativ ist es möglich, insbesondere bei Rasterelektronenmikroskopen, den Antikontaminator und/oder den Probenhalter (37), auf der von der Elektronenquelle (32) abgewandten Seite der Objektivlinse (34) innerhalb einer Probenkammer (35) anzuordnen, wie dieses in Figur 3 dargestellt ist. Das Rasterelektronenmikroskop in Figur 3 hat ebenfalls eine Elektronenquelle (32) und dieser nachfolgend mehrere Elektroden (33a, 33b) zur Beschleunigung der aus der Elektronenquelle (32) austretenden Elektronen. Auf die Elektroden folgt eine magnetische Kondensorlinse (41) und eine Objektivlinse (34). Die Objektivlinse (34) kann dabei eine magnetische, eine elektrostatische oder eine Kombination aus einer magnetischen und einer elektrostatischen Linse sein.

Auf die Objektivlinse folgt eine Probenkammer (35), in der ein Probenhalter (38) über einen Probenmanipulator (36) aufgenommen ist. Über einen Antrieb (37) ist der Probenhalter in drei zueinander senkrechten Richtungen verschiebbar sowie um eine senkrecht zur optischen Achse der Elektronenoptik (41, 34) stehende Achse kippbar.

Durch das Objektiv (34) werden die aus der Elektronenquelle (32) austretenden Elektronen auf einer auf dem Probenhalter (38) aufnehmbaren Probe fokussiert. Durch ein in der Objektivlinse (34) angeordnetes Ablenksystem (43) ist der Elektronenfokus senkrecht zur optischen Achse auslenkbar, wodurch die Probe abgerastert werden kann. Im Inneren der elektronenoptischen Säule sind noch Druckstufenblenden (44, 45) angeordnet, durch die erreicht wird, dass bei konstantem Vakuum im Bereich der Elektronenquelle der Druck in der Probenkammmer variiert werden kann. Es handelt sich dann um ein sogenanntes "Variable Pressure SEM", mit dem die Proben auch in sehr schlechtem Vakuum in der Probenkammer untersucht werden können.

Auch in diesem Ausführungsbeispiel ist eine Kühlung des Präparathalters (38) vorgesehen. Dazu ist wiederum außerhalb der Probenkammer ein zur Aufnahme eines flüssigen Kryogens geeignetes Deward- Gefäß (41) vorgesehen. Die das Kryogen (42) umschließende Wand des Deward-Gefäß ist im unteren Wandbereich von einem metallischen Kühler (40)n umgeben, der über einen Wärmeleiter (39) thermisch leitend mit dem Probenhalter (38) verbunden ist. Auch hier besteht der Wärmeleiter (39) aus einem Kohlefaserbündel. Die thermisch leitende Verbindung zwischen dem Wärmeleiter (39) und dem Kühler (40) sowie dem Probenhalter (38) ist in gleicher Weise realisiert wie in dem Ausführungsbeispiel in Figur 1.

Durch Abkühlen des Probenhalters (38) und der darauf aufgenommenen Probe wird erreicht, dass aus der Probe austretender Wasserdampf wieder auf der Probe kondensiert und die Probe so ihren Wassergehalt annähernd beibehält und der Wasserdampf nicht das Vakuum verschlechtert.

Anhand der vorstehenden Ausführungsbeispiele wurde die Erfindung am Beispiel elektronenoptischer Geräte erläutert. Die Erfindung ist jedoch gleicher Massen auch bei Geräten einsetzbar, bei denen Strahlen positiv geladener Ladungsträger, wie Ionen oder Positronen, eingesetzt werden.

## Patentansprüche

1. Teilchenstrahlgerät mit einem Objektiv, das einen Teilchenstrahl fokussiert oder abbildet, einem Probenhalter, auf den eine Probe in dem Objektiv oder in der Nähe des Objektivs aufnehmbar ist, einem Kühler und einem Wärmeleiter, wobei der Wärmeleiter (19) zur Ableitung von Wärme vom Probenhalter (17) oder von in der Nähe des Probenhalters (17) angeordneten Kühlflächen (18) zum Kühler (21) dient, und wobei der Wärmeleiter (19) Kohlefasern (24) enthält, wobei mindestens eines der beiden nachfolgenden Merkmale a) und b) zusätzlich erfüllt ist:
a) der Wärmeleiter (19) /besteht aus einem biegsamen Kohlefaserbündel,
b) ein Behälter (20) zur Aufnahme eines flüssigen Kryogens (22) ist vorgesehen und der Kühler (21) ist in oder an dem Behälter (20) angeordnet.

2. Teilchenstrahlgerät nach Anspruch 1, wobei das Teilchenstrahlgerät eine Vakuumsäule (1) aufweist, der Kühler (20, 21) außerhalb der Vakuumsäule (1) angeordnet ist und der Wärmeleiter (19) vom Kühler (20, 21) ausgehend durch die Vakuumsäule (1) hindurch bis in das Innere der Vakuumsäule (1) hineingeführt ist.

3. Teilchenstrahlgerät nach Ansprüche 1 oder 2, wobei eine Teilchenquelle (2) und ein ein- oder mehrstufiges Beleuchtungssystem aus Magnetlinsen (10, 11, 12, 13) vorgesehen sind.

4. Teilchenstrahlgerät nach einem der Ansprüche 1-3, wobei der Wärmeleiter (19) in Teilbündel (19a, 19b) aufgeteilt ist und ein Teilbündel (19a) des Wärmeleiters (19) mit den Kühlflächen (18) verbunden ist und ein zweites Teilbündel (19b) des Wärmeleiters (19) mit dem Probenhalter (17) verbunden ist.

## Claims

1. Particle beam apparatus having an objective which focuses or images a particle beam, a sample holder on which it is possible to hold a sample in the objective or in the vicinity of the objective, a cooler and a thermal conductor, the thermal conductor (19) serving to dissipate heat from the sample holder (17), or from the cooling surfaces (18) arranged in the vicinity of the sample holder (17), to the cooler (21), and the thermal conductor (19) including carbon fibres (24), in which at least one of the two following features a) and b) is additionally fulfilled:
a) the thermal conductor (19) comprises a flexible carbon fibre bundle,
b) a container (20) for holding a liquid cryogen (22) is provided, and the cooler (21) is arranged in or on the container (20).

2. Particle beam apparatus according to Claim 1, in which the particle beam apparatus has a vacuum column (1), the cooler (20, 21) is arranged outside the vacuum column (1), and the thermal conductor (19) is guided in a fashion issuing from the cooler (20, 21) through the vacuum column (1) as far as into the interior of the vacuum column (1).

3. Particle beam apparatus according to Claim 1 or 2, in which there are provided a particle source (2) and a single-stage or multi-stage illumination system composed of magnetic lenses (10, 11, 12, 13).

4. Particle beam apparatus according to one of Claims 1-3, in which the thermal conductor (19) is subdivided into component bundles (19a, 19b), and one component bundle (19a) of the thermal conductor (19) is connected to the cooling surfaces (18), and a second component bundle (19b) of the thermal conductor (19) is connected to the sample holder (17).

## Revendications

1. Appareil de projection d'un faisceau de particules, doté d'un objectif qui concentre un faisceau de particules ou en forme l'image, d'un porte-échantillons sur lequel un échantillon peut être placé dans l'objectif ou à proximité de l'objectif, d'un refroidisseur et d'un conducteur de chaleur, le conducteur de chaleur (19) servant à évacuer vers le refroidisseur (21) la chaleur du porte-échantillons (17) ou de surfaces de refroidissement (18) disposées à proximité du porte-échantillons (17), le conducteur de chaleur (19) contenant des fibres de carbone (24),
au moins l'une des deux caractéristiques a) et b) ci-dessous étant de plus satisfaite :
a) le conducteur de chaleur (19) est constitué d'un faisceau flexible de fibres de carbone,
b) un récipient (20) de reprise d'un cryogène liquide (22) est prévu, le refroidisseur (21) étant disposé dans ou sur le récipient (20).

2. Appareil de projection d'un faisceau de particules selon la revendication 1, dans lequel l'appareil de projection d'un faisceau de particules présente une colonne sous vide (1) et dans lequel le refroidisseur (20, 21) est disposé à l'extérieur de la colonne sous vide (1) et le conducteur de chaleur (19) part du refroidisseur (20, 21) et traverse la colonne sous vide (1) jusqu'à pénétrer à l'intérieur de la colonne sous vide (1).

3. Appareil de projection d'un faisceau de particules selon les revendications 1 ou 2, dans lequel une source (2) de particules et un système d'éclairage en un ou plusieurs étages, constitué de lentilles magnétiques (10, 11, 12, 13), sont prévus.

4. Appareil de projection d'un faisceau de particules selon l'une des revendications 1 à 3, dans lequel le conducteur de chaleur (19) est divisé en faisceaux partiels (19a, 19b), un faisceau partiel (19a) du conducteur de chaleur (19) étant relié aux surfaces de refroidissement (18) et un deuxième faisceau partiel (19b) du conducteur de chaleur (19) étant relié au porte-échantillons (17).
